# EUROPEAN PATENT APPLICATION

(11) **EP 4 672 877 A1**
(43) Date of publication of application: **31.12.2025**
(21) Application number: 24760221.2
(22) Date of filing: 14.02.2024
(51) Int. Cl.: H05K 5/02

(54) **ELECTRONIC DEVICE ASSEMBLY, ELECTRONIC DEVICE, AND STAND**

(30) Priority: 21.02.2023 JP 2023025545
(71) Applicant: Sony Interactive Entertainment Inc., Tokyo 108-0075 (JP)
(72) Inventor: MORISAWA, Yujin, Tokyo 108-0075 (JP); ETO, Kazutaka, Tokyo 108-0075 (JP)
(74) Representative: Fish & Richardson P.C.
(86) International application number: PCT/JP2024/005081
(87) International publication number: WO 2024/176920

(57) **Abstract**

An electronic device is set in a stable manner. An electronic device (10) includes a curved lower surface (10D) and a circuit board (15) arranged in a posture along a direction intersecting with the up-down direction. The curved lower surface (10D) has regions (a, b) in which stands (40a, 40b) are provided and a support (23) the distance of which from a plane (L1) including the circuit board (15) is greatest.

## Description

### [Technical Field]

The present disclosure relates to an electronic device assembly, an electronic device, and a stand.

### [Background Art]

PTL 1 described below discloses an electronic device that can be used as a game device, a video reproducing device, etc. This electronic device has a device body that houses a circuit board, a cooling device, etc., and an exterior panel that is attached to the outer surface of the device body. The exterior panel is curved overall.

### [Citation List]

### [Patent Literature]

[PTL 1]
WO 2021/193881A

### [Summary]

### [Technical Problem]

Since the exterior panel of the electronic device of PTL 1 is curved overall, it is desirable to use a stand to stably set the electronic device when the device is placed on a desk, floor, or the like.

An object of the present disclosure is to stably set electronic devices.

### [Solution to Problem]

An electronic device assembly proposed in the present disclosure includes an electronic device and a first stand for supporting the electronic device, the first stand being attachable to and detachable from the electronic device. The electronic device includes a curved lower surface and a circuit board arranged in a posture along a direction intersecting with an up-down direction. The curved lower surface has a first position where the first stand is provided and a support a distance of which from a plane including the circuit board is greatest on the curved lower surface. This allows the electronic device to be set stably.

Further, an electronic device proposed in the present disclosure includes a curved lower surface and a circuit board arranged in a posture along a direction intersecting with an up-down direction. The curved lower surface has a first position where a first stand is provided and a support a distance of which from a plane including the circuit board is greatest on the curved lower surface. This allows the electronic device to be stably set by using the stand.

Further, a stand proposed in the present disclosure is a stand that is attachable to and detachable from an electronic device, the stand including a first leg that has an upper end for fitting into a first mounting portion of the electronic device and extends downward from the upper end and a second leg that has an upper end for fitting into a second mounting portion of the electronic device and extends downward from the upper end. The first leg and the second leg have a common lower end. This allows the electronic device to be set stably.

### [Brief Description of Drawings]

[FIG. 1]

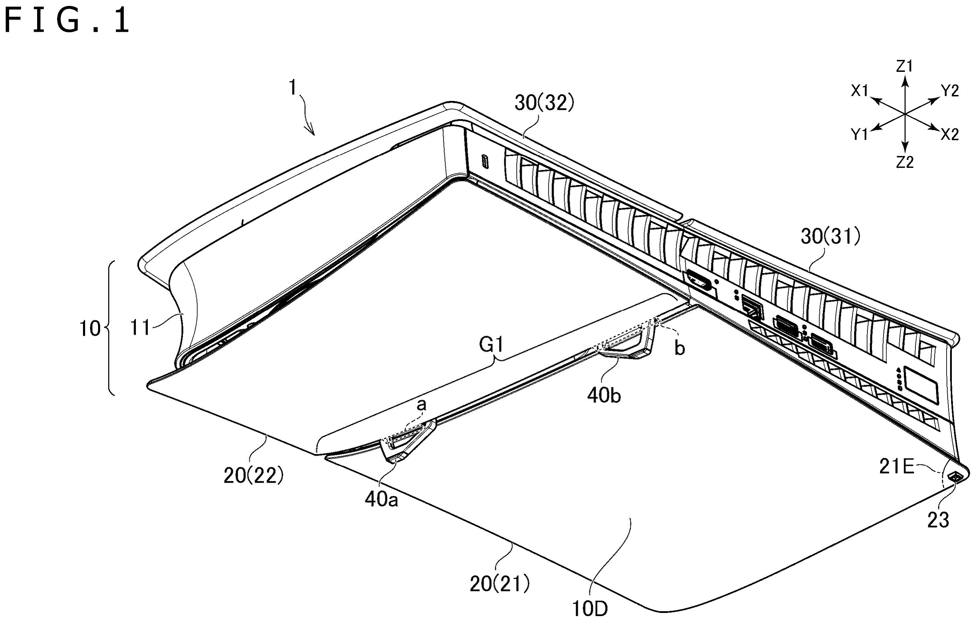

   FIG. 1 is a perspective view of an electronic device assembly according to an example of an embodiment.
[FIG. 2]

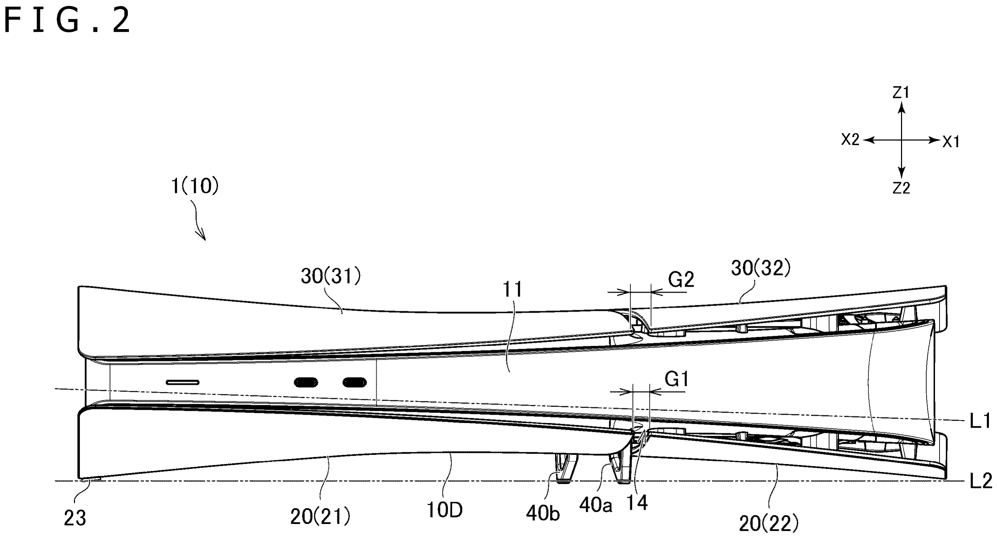

   FIG. 2 is a front view of the electronic device assembly.
[FIG. 3]

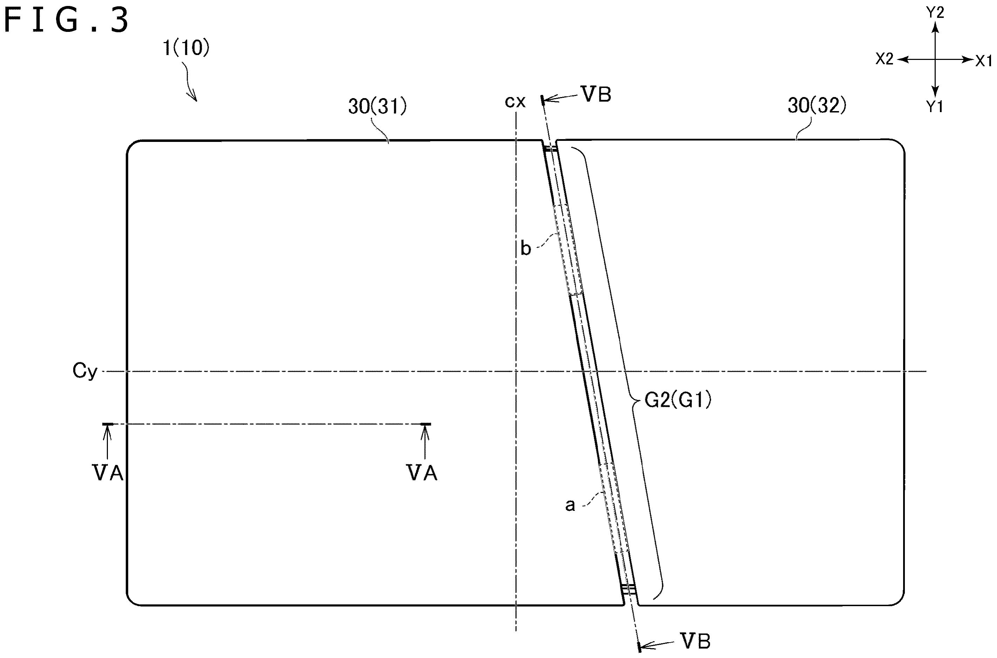

   FIG. 3 is a plan view of the electronic device assembly.
[FIG. 4]

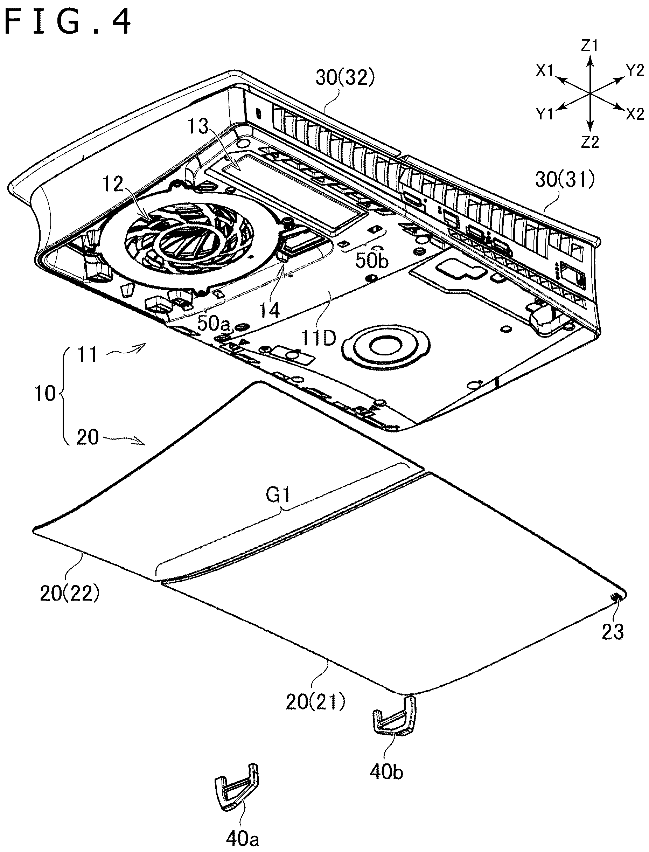

   FIG. 4 is an exploded perspective view of the electronic device assembly.
[FIG. 5A]

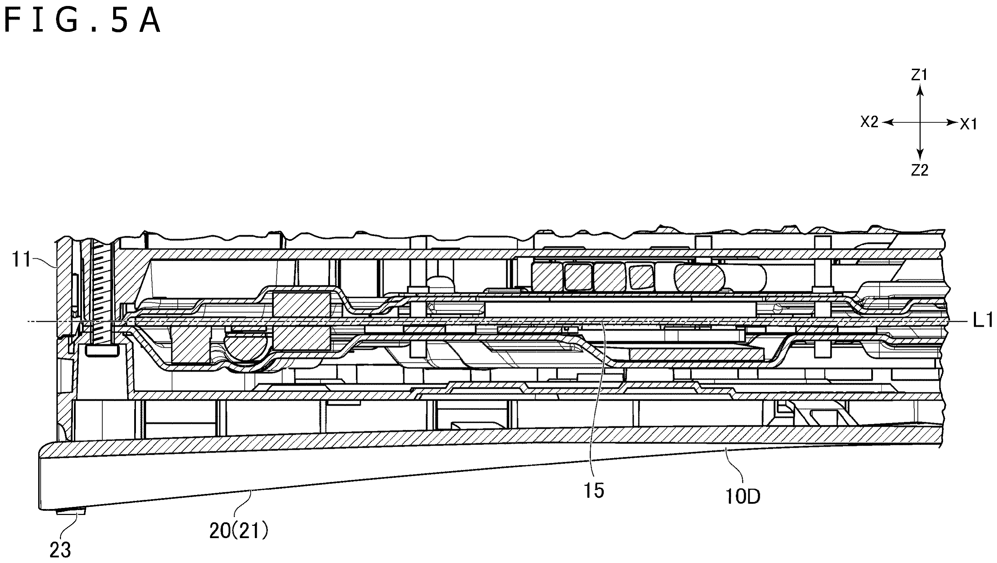

   FIG. 5A is a cross-sectional view of the electronic device assembly taken along a cutting surface including line VA-VA in FIG. 3.
[FIG. 5B]

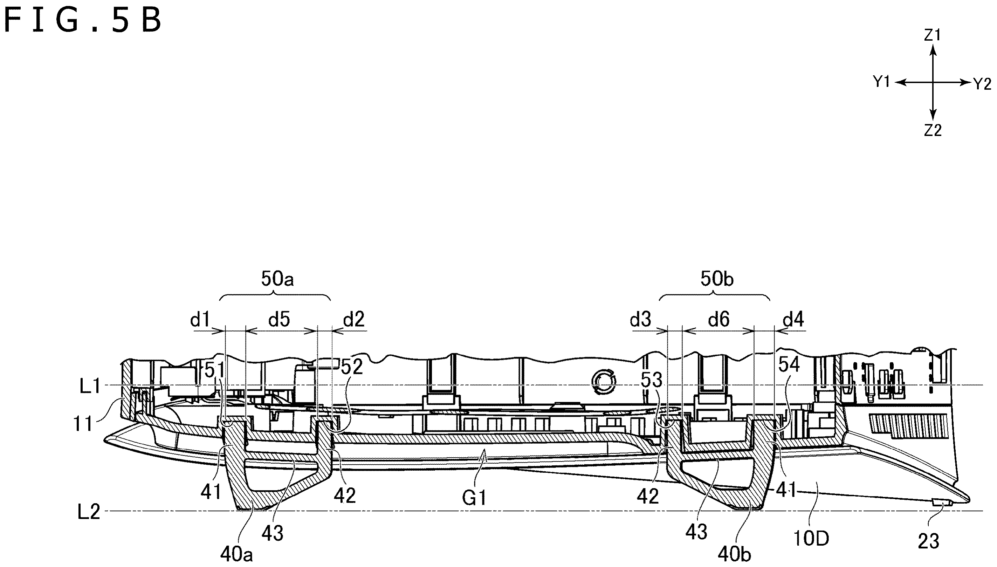

   FIG. 5B is a cross-sectional view of the electronic device assembly taken along a cutting surface including line VB-VB in FIG. 3.
[FIG. 6A]

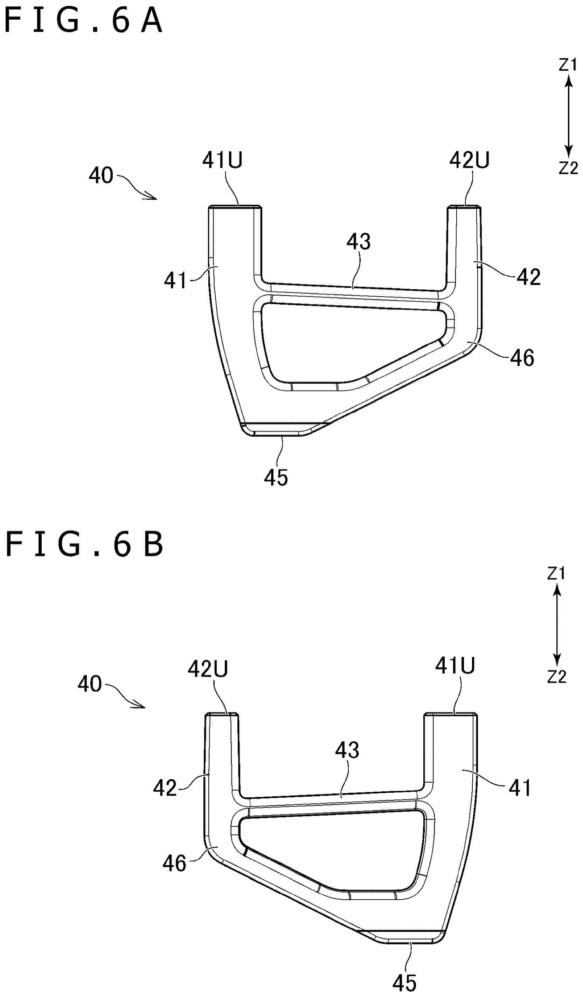

   FIG. 6A is a front view of a stand member.
[FIG. 6B]
   FIG. 6B is a rear view of the stand member.
[FIG. 6C]

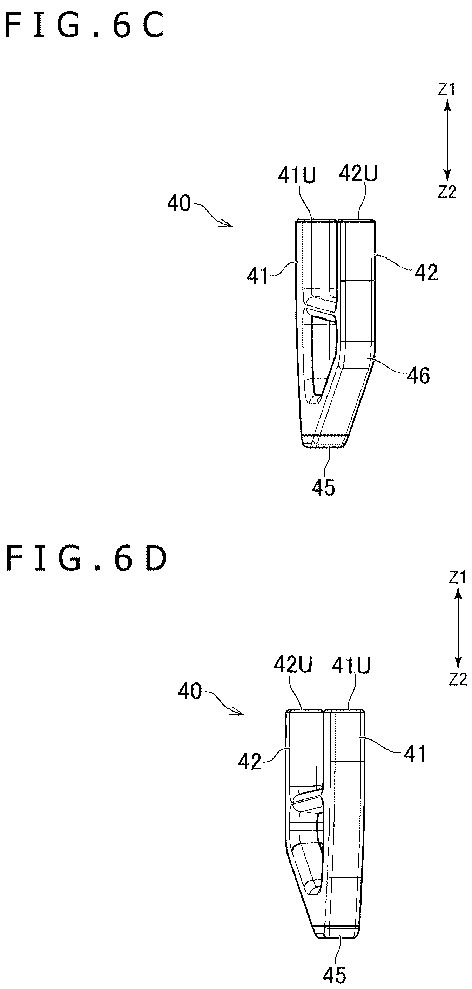

   FIG. 6C is a left side view of the stand member.
[FIG. 6D]
   FIG. 6D is a right side view of the stand member.
[FIG. 6E]

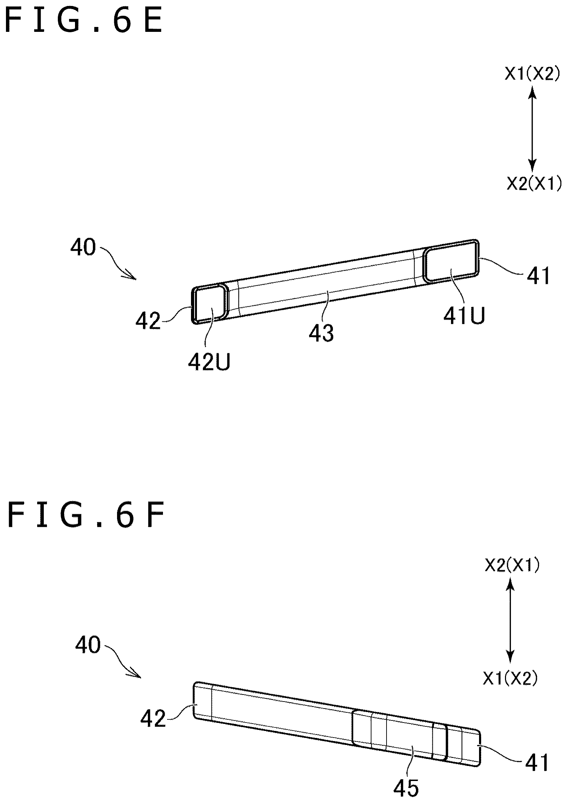

   FIG. 6E is a plan view of the stand member.
[FIG. 6F]
   FIG. 6F is a bottom view of the stand member.
[FIG. 7]

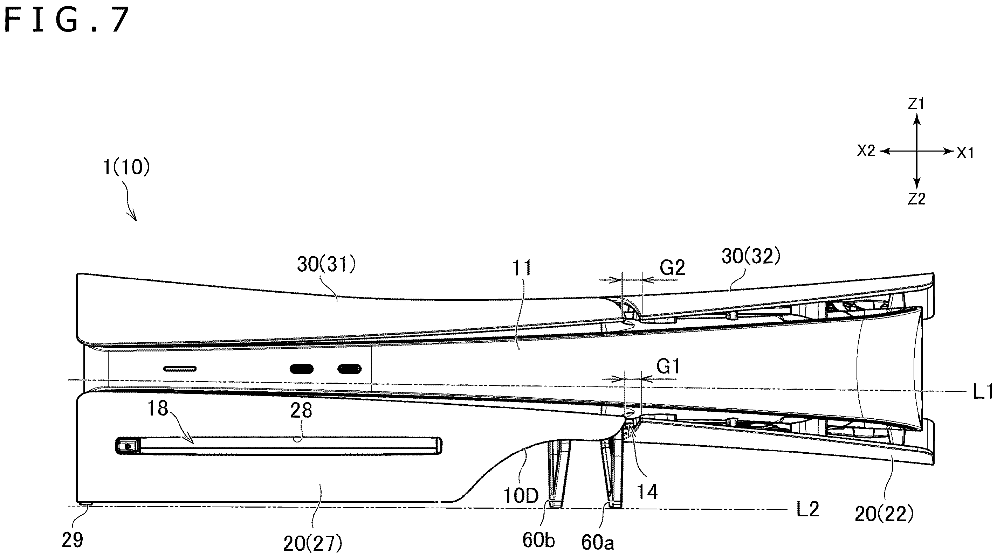

   FIG. 7 is a front view of an electronic device assembly that is another example of the embodiment.
[FIG. 8A]

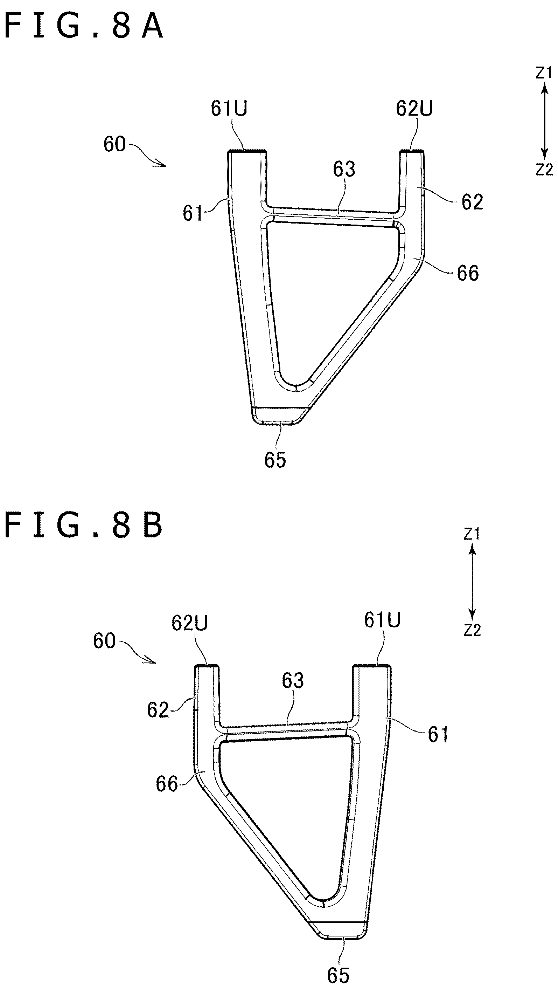

   FIG. 8A is a front view of a stand member.
[FIG. 8B]
   FIG. 8B is a rear view of the stand member.
[FIG. 8C]

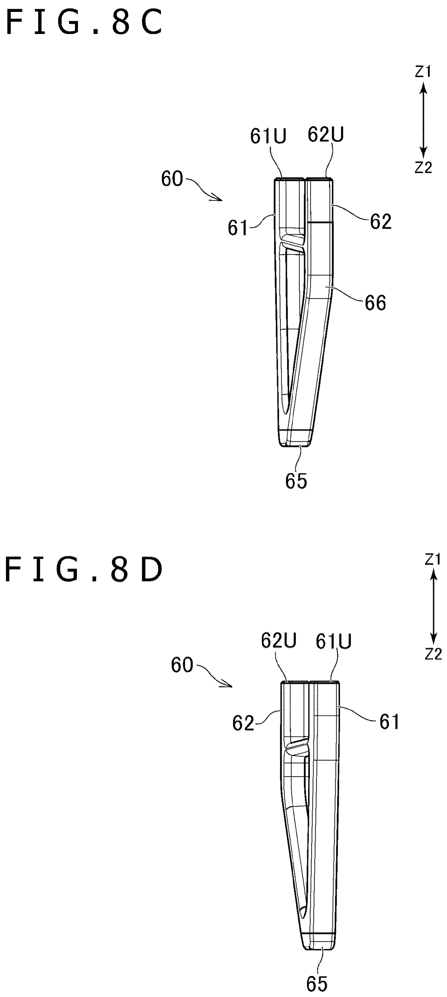

   FIG. 8C is a left side view of the stand member.
[FIG. 8D]
   FIG. 8D is a right side view of the stand member.
[FIG. 8E]

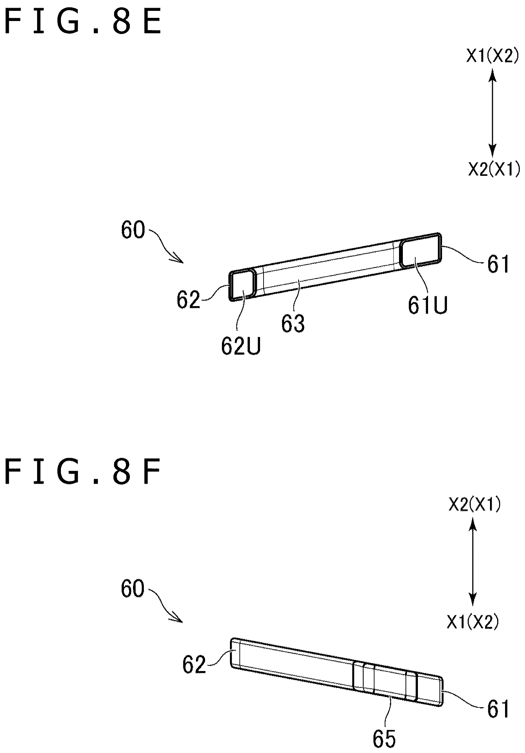

   FIG. 8E is a plan view of the stand member.
[FIG. 8F]
   FIG. 8F is a bottom view of the stand member.

### [Description of Embodiment]

### [1. Overview of IC Chip and Heat Radiator]

An electronic device assembly, an electronic device, and a stand proposed in the present disclosure will be described below with reference to the drawings. FIG. 1 is a perspective view of an electronic device assembly 1 which is an example of an embodiment proposed in the present disclosure. FIG. 2 is a front view of the electronic device assembly 1. FIG. 3 is a plan view of the electronic device assembly 1. FIG. 4 is an exploded perspective view of the electronic device assembly 1. FIG. 5A is a cross-sectional view of the electronic device assembly 1 taken along a cutting surface including VA-VA line in FIG. 3. FIG. 5B is a cross-sectional view of the electronic device assembly 1 taken along a cutting surface including VB-VB line in FIG. 3.

In the following description, Z1 and Z2 directions of a Z-axis illustrated in FIG. 1 and elsewhere are referred to as upward and downward directions, respectively. Further, X1 and X2 directions of an X-axis perpendicular to the Z-axis are referred to as rightward and leftward directions, respectively. In addition, Y1 and Y2 directions of a Y-axis perpendicular to the Z- and X-axes are referred to as forward and backward directions, respectively. However, these directions are specified for explaining the shapes of elements such as parts, members, and portions of the electronic device assembly 1 and the relative positional relations between the respective elements, for example, and do not limit the posture of the electronic device assembly 1 during use.

As illustrated in FIG. 1, the electronic device assembly 1 is a structure in which an electronic device 10 and a stand for supporting the electronic device 10 (for example, a front stand 40a and a rear stand 40b to be described later) are combined. As illustrated in FIG. 1, the electronic device 10 has a curved lower surface 10D. Also, as illustrated in FIG. 4, the electronic device 10 has a device body 11 and a lower panel 20 (exterior panel) attached to a lower surface 11D of the device body 11. As illustrated in FIG. 5A, the device body 11 houses a circuit board 15. The circuit board 15 is arranged inside the device body 11 in a posture along a direction intersecting with the up-down direction (Z-axis direction). The circuit board 15 may be arranged in a posture of facing the lower panel 20. The circuit board 15 may be arranged in a posture along the front-rear direction (Y-axis direction) and the left-right direction (X-axis direction).

As illustrated in FIG. 1, the curved lower surface 10D of the electronic device 10 is formed by the lower panel 20 (exterior panel). As illustrated in FIG. 4, the lower panel 20 has a left portion panel 21 (first portion panel) arranged on the left side (X2 side; right side in FIG. 4) of the device body 11 and a right portion panel 22 (second portion panel) arranged on the right side (X1 side; left side in FIG. 4) of the device body 11. The right portion panel 22 covers a portion of the lower surface 11D of the device body 11 (a portion where a cooling fan 12 and a storage medium housing chamber 13 are provided), and the left portion panel 21 covers another portion of the lower surface 11D. The curved lower surface 10D of the electronic device 10 is formed by the lower surface of the right portion panel 22 and the lower surface of the left portion panel 21.

The lower panel 20 (the left portion panel 21 and the right portion panel 22) is attachable to and detachable from the device body 11. Further, the electronic device 10 has a curved upper panel 30 that covers the upper surface of the device body 11, as illustrated in FIG. 1. Like the lower panel 20, the upper panel 30 also has a right portion panel 32 arranged on the right side (X1 side; left side in FIG. 1) of the device body 11 and a left portion panel 31 arranged on the left side (X2 side; right side in FIG. 1) of the device body 11. The upper panel 30 (the right portion panel 32 and the left portion panel 31) may also be attachable to and detachable from the device body 11.

As illustrated in FIGS. 1 and 2, while the lower panel 20 is attached to the device body 11, a gap G1 is formed between the left portion panel 21 and the right portion panel 22 constituting the lower panel 20. As illustrated in FIG. 4, in the present embodiment, the left portion panel 21 and the right portion panel 22 are separate members independent of each other. Therefore, as illustrated in FIG. 1, the gap G1 is continuously formed in a region from the front end (end on the Y1 side) to the rear end (end on the Y2 side) of the lower panel 20. The gap G1 extends from the front end of the lower panel 20 rearward and leftward (the direction indicated by X2, the rightward direction in FIG. 1) in an oblique direction. In other words, the gap G1 extends from the front end to the rear end of the electronic device 10 on the lower surface 10D of the electronic device 10 and is inclined in the left-right direction. The lower panel 20 has the left portion panel 21 and the right portion panel 22, and thus covers substantially the entire lower surface 11D of the device body 11 except for the gap G1. Further, the gap G1 that is not covered by the lower panel 20 exposes portions where mounting portions 50a and 50b (to be described later) are formed.

It is to be noted that the lower panel 20 may be integrally formed to include the left portion panel 21 and the right portion panel 22. In this case, the right portion panel 22 may be connected to the left portion panel 21. Even in this case, in order that the mounting portions 50a and 50b to be described later, which are formed on the lower surface 11D of the device body 11, may be exposed downward, it is preferable to provide the gap G1 partially between the left portion panel 21 and the right portion panel 22 or to provide openings corresponding to the mounting portions 50a and 50b.

As illustrated in FIG. 4, a ventilation hole of the cooling fan 12 is formed inside a recess 14 recessed upward from the lower surface 11D of the device body 11. A right region (recess 14) of the lower surface 11D is recessed relative to a left region thereof, and the ventilation hole of the cooling fan 12 is formed in this right region. An air flow path is formed between the right region (recess 14) of the lower surface 11D and the lower panel 20. The gap G1 between the left portion panel 21 and the right portion panel 22 overlaps with at least a portion of the recess 14 as illustrated in FIG. 2. That is, in the bottom view of the electronic device 10, the gap G1 is located inside the right region (recess 14) of the lower surface 11D. Therefore, the gap G1 exposes at least a portion of the recess 14 downward. In the example illustrated in FIG. 4, the gap G1 exposes the right end (the end on the X2 side) of the recess 14. In this way, the gap G1 functions as a ventilation hole, and an air flow path from the outside of the electronic device 10 to the cooling fan 12 can be secured.

As illustrated in FIG. 3, while the upper panel 30 is attached to the device body 11, a gap G2 is formed between the right portion panel 32 and the left portion panel 31 constituting the upper panel 30. The gap G2 is formed continuously in a region from the front end (end on the Y1 side) to the rear end (end on the Y2 side) of the upper panel 30, and extends rearward (Y2 direction) and leftward (X2 direction) obliquely from the front end of the lower panel 20, similarly to the gap G1 (see FIG. 1). In the present embodiment, the gap G1 of the lower panel 20 is formed at the same position as the gap G2 of the upper panel 30 in a plan view. In the plan view illustrated in FIG. 3, the gap G1 overlaps with the gap G2. The entire regions of the gaps G1 and G2 are provided on the right side (X1 side) of a center position cx (see the alternate long and short dash line) in the left-right direction (direction along the X-axis in FIG. 3) of the electronic device 10.

As illustrated in FIG. 1, the electronic device assembly 1 has the front stand 40a (first stand, hereinafter also referred to simply as the stand 40a) and the rear stand 40b (second stand, hereinafter also referred to simply as the stand 40b) for supporting the electronic device 10. The stands 40a and 40b are attachable to and detachable from the electronic device 10. The curved lower surface 10D of the electronic device 10 has a region a (first position) where the front stand 40a is provided, and a region b (second position) where the rear stand 40b is provided.

In FIG. 3, the gap G1 of the lower panel 20 and the regions a and b in which the stands 40a and 40b are furnished are provided on a side (lower side) opposite to the front side (upper side) illustrated in FIG. 3. In FIG. 3, the regions a and b are indicated by broken lines. The region a is provided on the front side of a center position cy (see the alternate long and short dash line) in the front-rear direction of the electronic device 10 (direction along the Y-axis in FIG. 3), and the region b is provided on the rear side of the center position cy. The stands 40a and 40b can be attached to and detached from these regions a and b. In other words, the stands 40a and 40b can be attached to the front side and rear side of the center position cy of the electronic device 10. As illustrated in FIG. 5B, the stands 40a and 40b support the electronic device 10 at positions shifted in the front-rear direction (Y-axis direction in FIG. 5B). This makes it possible to stably set the electronic device 10 on an installation surface L2 such as a floor surface (see the alternate long and short dash line in FIG. 5B).

As illustrated in FIG. 1, the region a in which the front stand 40a is provided is defined in the gap G1 between the left portion panel 21 and the right portion panel 22 that constitute the lower panel 20. Similarly to this, the region b in which the rear stand 40b is provided is also defined in the gap G1 between the left portion panel 21 and the right portion panel 22. As illustrated in FIG. 3, the regions a and b are defined inside the gap G1 in a plan view. Note that the lower surface 10D of the electronic device 10 in a portion where the gap G1 is formed is a virtual surface that connects the lower surface of the right portion panel 22 and the lower surface of the left portion panel 21 to each other.

As illustrated in FIG. 4 and FIG. 5B, the lower surface 11D of the device body 11 has the front mounting portion 50a (hereinafter also simply referred to as the mounting portion 50a) to which the front stand 40a can be attached and the rear mounting portion 50b (hereinafter also simply referred to as the mounting portion 50b) to which the rear stand 40b can be attached. In the example illustrated in FIG. 4 and FIG. 5B, the mounting portions 50a and 50b have holes formed in the lower surface 11D. To be more specific, as illustrated in FIG. 5B, the front mounting portion 50a has a hole 51 and a hole 52. Also, the rear mounting portion 50b has a hole 53 and a hole 54. The holes 51 to 54 are arranged in this order from one side (the front side; the left side in FIG. 5B) to the other side (the rear side; the right side in FIG. 5B) in a direction along the circuit board 15 (see FIG. 5A). In the present embodiment, the holes 51 to 54 are recesses in which the side of the lower surface 11D of the device body 11 is recessed upward. Therefore, members and electronic components housed in the device body 11 are not exposed at the holes 51 to 54.

The holes 51 and 52 of the front mounting portion 50a (see FIG. 5B) are provided in the region a (see FIG. 3) inside the gap G1 between the left portion panel 21 and the right portion panel 22 constituting the lower panel 20 in a plan view. Further, the holes 53 and 54 of the rear mounting portion 50b (see FIG. 5B) are provided in the region b (see FIG. 3) inside the gap G1 in a plan view. Therefore, the holes 51 to 54 are exposed from the gap G1. This allows the stands 40a and 40b to be inserted into the holes of the mounting portions 50a and 50b in a state in which the lower panel 20 is attached to the device body 11. The stands 40a and 40b are arranged apart from each other along the gap G1 on the lower surface 11D of the device body 11. Therefore, the air resistance caused by the stands 40a and 40b can be reduced for the gap G1 that functions as a ventilation hole to the cooling fan 12 (see FIG. 4).

As illustrated in FIGS. 1 and 2, the curved lower surface 10D of the electronic device 10 has a support 23 for supporting the electronic device 10, in addition to the stands 40a and 40b. The support 23 is formed on the left portion panel 21 among the left portion panel 21 and the right portion panel 22 that constitute the lower panel 20. The support 23 is provided on a protrusion formed on the left portion panel 21. To be more specific, the support 23 is the lower end of a protrusion formed on a corner 21E of the left portion panel 21 (a portion where the outer edge on the X2 side and the outer edge on the Y2 side are connected to each other).

The distance in the up-down direction (Z-axis direction) from a plane L1 (see FIG. 5A and the alternate long and two short dashes lines in FIGS. 2 and 5B) including the circuit board 15 (see FIG. 5A) housed in the device body 11 to the lower surface 10D is greatest at the support 23. The plane L1 is a flat surface that includes the circuit board 15 and extends along the surface of the circuit board 15. The plane L1 is a surface that is substantially parallel to the installation surface L2 (see the alternate long and two short dashes lines in FIGS. 2 and 5B) such as a floor surface on which the electronic device assembly 1 is set.

When the electronic device assembly 1 is set in the posture illustrated in FIG. 2, the lower ends of the stands 40a and 40b and the support 23 come into contact with the installation surface L2 (see the alternate long and two short dashes line in FIG. 2) such as a floor surface. This allows the electronic device 10 to be stably set on the installation surface L2. In addition, the protrusion on which the support 23 is provided projects downward from the lower surface 10D of the electronic device 10. This makes it possible to prevent portions of the lower surface 10D of the electronic device 10 other than the protrusion from coming into direct contact with the installation surface L2.

The left portion panel 21 and the right portion panel 22 that constitute the lower panel 20 may be formed of resin. Also, the support 23 (for example, the entire protrusion on which the support 23 is provided) of the left portion panel 21 may be formed of a material that is softer than the resin used to form the panel, such as rubber or elastomer. In this way, the support 23 can be prevented from slipping on the installation surface L2 such as a floor surface.

As illustrated in FIG. 2, the distance from the plane L1 (a plane including the circuit board 15 illustrated in FIG. 5A) to the lower end of the front stand 40a is substantially the same as the distance from the plane L1 to the support 23. Also, the distance from the plane L1 to the lower end of the rear stand 40b is substantially the same as the distance from the plane L1 to the support 23. This makes it possible to prevent the circuit board 15 and the device body 11 housing it from tilting with respect to the installation surface L2 when the electronic device assembly 1 is set on the installation surface L2 such as a floor surface.

As illustrated in FIG. 1, the support 23 is formed at the corner 21E of the left portion panel 21. Further, the width of the left portion panel 21 in the left-right direction
(X-axis direction) along the plane L1 (see FIG. 2) including the circuit board 15 (see FIG. 5A) is larger than the width of the right portion panel 22 in the same direction. Due to this, the distance from the front stand 40a to the support 23 and the distance from the rear stand 40b to the support 23 in the left-right direction are larger than half the length of the electronic device assembly 1 in the left-right direction. This makes it possible to support the electronic device 10 more stably.

As illustrated in FIG. 1 and FIG. 3, the gap G1 between the left portion panel 21 and the right portion panel 22 constituting the lower panel 20 extends in a direction oblique to the front-rear direction (Y-axis direction). Therefore, as illustrated in FIG. 2, the position of the front stand 40a attached to the front side of the electronic device 10 along the gap G1 and the position of the rear stand 40b attached to the rear side of the electronic device 10 along the gap G1 are shifted in the left-right direction (X-axis direction). One of the stands 40a and 40b is located to the left of the other. In the example illustrated in FIG. 2, the front stand 40a is located to the right (X1 direction) of the rear stand 40b. In other words, the rear stand 40b is located to the left (X2 direction) of the front stand 40a. In this way, the stands 40a and 40b support the electronic device 10 at positions shifted in the left-right direction. This makes it possible to support the electronic device 10 more stably.

The front stand 40a and the rear stand 40b have the same shape. This makes it possible to reduce the manufacturing costs of the front stand 40a and the rear stand 40b compared to a case in which the front stand 40a and the rear stand 40b have different shapes.

FIGS. 6A to 6F illustrate stand members 40 which are the front stand 40a and the rear stand 40b. FIG. 6A is a front view of the stand member 40. FIG. 6B is a rear view of the stand member 40. FIG. 6C is a left side view of the stand member 40. FIG. 6D is a right side view of the stand member 40. FIG. 6E is a plan view of the stand member 40. FIG. 6F is a bottom view of the stand member 40. Note that the "front," "rear," "right side," and "left side" herein do not coincide with the front-rear direction and the left-right direction indicated by the X-axis and the Y-axis in FIGS. 1 to 5.

As illustrated in FIGS. 1 and 2, the front stand 40a and the rear stand 40b face in directions opposite to each other when attached to the electronic device 10. In the front view illustrated in FIG. 2, the front stand 40a allows the right side illustrated in FIG. 6D to be seen, and the rear stand 40b allows the left side illustrated in FIG. 6C to be seen. In this manner, the front stand 40a and the rear stand 40b are arranged symmetrically.

As illustrated in FIGS. 5B, 6A, etc., each of the stand members 40 (front stand 40a and rear stand 40b) has two legs 41 and 42 that are attached to the electronic device 10 in the up-down direction (Z-axis direction). The leg 41 (first leg) has an upper end 41U for fitting into the electronic device 10 and extends downward from the upper end 41U. Further, the leg 42 (second leg) also has an upper end 42U for fitting into the electronic device 10 and extends downward from the upper end 42U.

As illustrated in FIG. 5B, the upper end 41U (see FIG. 6A) of the leg 41 of the front stand 40a is fitted into the hole 51 (first mounting portion) of the front mounting portion 50a, and the upper end 42U (see FIG. 6A) of the leg 42 of the front stand 40a is fitted into the hole 52 (second mounting portion) of the front mounting portion 50a. Similarly to this, the upper end 41U of the leg 41 of the rear stand 40b is fitted into the hole 54 (first mounting portion) of the rear mounting portion 50b, and the upper end 42U of the leg 42 of the rear stand 40b is fitted into the hole 53 (second mounting portion) of the rear mounting portion 50b. Due to this, the stands 40a and 40b are attached to the electronic device 10 (more specifically, to the lower surface 11D of the device body 11).

As illustrated in FIG. 3, the gap G1 between the left portion panel 21 and the right portion panel 22 constituting the lower panel 20 is provided on the side (lower side) opposite to the front side (upper side) illustrated in FIG. 3. Here, the gap G1 extends in an oblique direction (first direction) relative to the left-right direction (X-axis direction) and the front-rear direction (Y-axis direction). Also, the legs 41 and 42 formed on each stand member 40 are spaced apart from each other in the oblique direction in which the gap G1 extends, as illustrated in FIG. 6E.

The legs 41 and 42 of the stand member 40 have a width corresponding to the width of the gap G1 in the left-right direction (X-axis direction). Further, since the direction in which the legs 41 and 42 are separated from each other coincides with the direction in which the gap G1 extends, the legs 41 and 42 of each stand member 40 can be inserted into the gap G1. As illustrated in FIG. 6A, the legs 41 and 42 are connected to each other by a beam 43 extending along the gap G1. This provides reinforcement to the legs 41 and 42. In a state where the stand members 40, which are the stands 40a and 40b, are attached to the electronic device 10, the beam 43 (see FIG. 5B) fits inside the gap G1 (see FIGS. 1 and 5B).

As illustrated in FIG. 6A, the legs 41 and 42 of the stand member 40 have a common lower end 45. In the stand member 40, the lower end 45 is a portion that comes into contact with the installation surface L2 (see FIG. 2 etc.) such as a floor surface, and is also referred to as a contact portion 45 below. Substantially the entire stand member 40 (portions including the legs 41 and 42 and the beam 43) may be formed of resin. The contact portion 45 may be formed of a material that is softer than resin, such as rubber or elastomer. In this way, the strength of the stand member 40 is ensured, and the stands 40a and 40b can be prevented from slipping on the installation surface L2.

As illustrated in FIG. 6A, the leg 41 of the stand member 40 is slightly curved and connected to the contact portion 45 at the lower end. In contrast, a bent portion 46 bending toward the contact portion 45 is formed between the upper end 42U of the leg 42 and the contact portion 45. Here, the leg 41 of the stand member 40 is thicker in the oblique direction along the gap G1 (the left-right direction in FIG. 6A) than the leg 42. In this way, the strength of the stand member 40 can be ensured by providing the two legs 41 and 42 connected to the contact portion 45 and further increasing the thickness of the leg 41 extending from the contact portion 45 without bending.

As illustrated in FIG. 5B, the hole 51 (first mounting portion) of the front mounting portion 50a and the hole 54 (first mounting portion) of the rear mounting portion 50b, into which the legs 41 of the stand members 40 are fitted, have a width corresponding to the width of the leg 41. In the direction in which the gap G1 extends (the left-right direction in FIG. 5B), a width d1 of the hole 51 and a width d4 of the hole 54 are the same and are substantially equal to the width of the leg 41. Similarly to this, the hole 52 (second mounting portion) of the front mounting portion 50a and the hole 53 (second mounting portion) of the rear mounting portion 50b, into which the legs 42 of the stand members 40 are fitted, also have a width corresponding to the width of the leg 42. In the direction in which the gap G1 extends, a width d2 of the hole 52 and a width d3 of the hole 53 are the same and are substantially equal to the width of the leg 42. In addition, a distance d5 between the holes 51 and 52 of the front mounting portion 50a is also the same as a distance d6 between the holes 53 and 54 of the rear mounting portion 50b. The distances d5 and d6 are substantially equal to the distance between the leg 41 and the leg 42. For this reason, the stand members 40 of the same shape can be attached to the front mounting portion 50a and the rear mounting portion 50b as the front stand 40a and the rear stand 40b.

### [3. Modifications]

It should be noted that the present invention is not limited to the above embodiment.

(1) FIG. 7 is a front view of the electronic device assembly 1 according to another example of the embodiment. In the example illustrated in FIG. 7, a left portion panel 27 having a different shape from the left portion panel 21 illustrated in FIG. 2 is attached. In the example illustrated in FIG. 7, the left portion panel 27 and the right portion panel 22 constitute the lower panel 20 and the curved lower surface 10D of the electronic device 10.

The left portion panel 27 illustrated in FIG. 7 bulges significantly downward (in the Z2 direction) compared to the left portion panel 21 illustrated in FIG. 2. Further, in the example illustrated in FIG. 7, an optical disk drive 18 is arranged between the lower surface 11D (see FIG. 4) of the device body 11 and the left portion panel 27. Further, an opening 28 is formed in the left portion panel 27. The opening 28 exposes the optical disk drive 18 forward.

Similarly to the electronic device assembly 1 illustrated in FIG. 2, the electronic device assembly 1 illustrated in FIG. 7 also has a front stand 60a (first stand, hereinafter also simply referred to as the stand 60a) and a rear stand 60b (second stand, hereinafter also simply referred to as the stand 60b) for supporting the electronic device 10. The curved lower surface 10D of the electronic device 10 has, in the gap G1 between the left portion panel 27 and the right portion panel 22, a region (first position) where the front stand 60a is provided and a region (second position) where the rear stand 60b is provided. The mounting portions 50a and 50b (see FIG. 4) to which the stands 60a and 60b are attached are formed in these regions.

In addition, as illustrated in FIG. 7, the left portion panel 27 has a support 29 for supporting the electronic device 10. The support 29 is also the lower end of a protrusion formed on the left portion panel 21, similar to the support 23 illustrated in FIG. 2. Also in the example illustrated in FIG. 7, the distance in the up-down direction (Z-axis direction) from the plane L1 (see FIG. 5A and the alternate long and two short dashes line in FIG. 7) including the circuit board 15 (see FIG. 5A) to the lower surface 10D is greatest at the support 29. Since the support 29 is made of a material that is softer than resin, such as rubber or elastomer, the support 29 can be prevented from slipping on the installation surface L2 such as a floor surface.

Also in the example illustrated in FIG. 7, the lower ends of the stands 60a and 60b and the support 29 come into contact with the installation surface L2 (see the alternate long and two short dashes line in FIG. 7) such as a floor surface, thereby enabling the electronic device 10 to be set stably. In addition, since the support 29 is provided at the lower end of the protrusion, portions of the lower surface 10D of the electronic device 10 other than the protrusion can be prevented from coming into direct contact with the installation surface L2.

Also in the example illustrated in FIG. 7, the front stand 60a and the rear stand 60b have the same shape. FIGS. 8A to 8F illustrate stand members 60 which are the front stand 60a and the rear stand 60b. FIG. 8A is a front view of the stand member 60. FIG. 8B is a rear view of the stand member 60. FIG. 8C is a left side view of the stand member 60. FIG. 8D is a right side view of the stand member 60. FIG. 8E is a plan view of the stand member 60. FIG. 8F is a bottom view of the stand member 60. Note that the "front," "rear," "right side," and "left side" here do not coincide with the front-rear direction and the left-right direction indicated by the X-axis and the Y-axis in FIG. 7.

As illustrated in FIG. 8A and the like, the stand members 60, which are the front stand 60a and the rear stand 60b, each also have two legs 61 and 62, similarly to the stand member 40 illustrated in FIG. 6A and the like. The leg 61 (first leg) has an upper end 61U that fits into the hole 51 or the hole 54 (first mounting portion, see FIG. 5B) of the electronic device 10, and extends downward from the upper end 61U. Further, the leg 62 (second leg) has an upper end 62U that fits into the hole 52 or the hole 53 (second mounting portion, see FIG. 5B) of the electronic device 10, and extends downward from the upper end 42U. The legs 61 and 62 have a contact portion 65 as a common lower end. The contact portion 65 includes rubber, elastomer, or the like, so that the stand member 60 can be prevented from slipping on the installation surface L2.

In the example illustrated in FIG. 7, the distance from the plane L1 including the circuit board 15 to the support 29 is greater than the distance from the plane L1 to the support 23 illustrated in FIG. 2. The electronic device 10 illustrated in FIG. 7 is greater in height in the up-down direction (Z-axis direction) than the electronic device 10 illustrated in FIG. 2. Therefore, the stand member 60 (see FIG. 8A etc.) for supporting the electronic device 10 in FIG. 7 is also greater in height in the up-down direction than the stand member 40 (see FIG. 6A etc.). In this way, the electronic device 10 can be stably set on the installation surface L2 such as a floor surface, by the support 29 and the stand members 60 (stand 60a and stand 60b).

(2) In the embodiment, an example has been described in which the two stands 40a and 40b are attached to the electronic device 10. However, the present invention is not limited to this example, and the number of stands attached to the electronic device 10 may be one or may be three or more.

For example, the front stand 40a and the rear stand 40b illustrated in FIG. 5B may be configured as one member. In this case, a beam may be formed between the leg 42 of the front stand 40a and the leg 42 of the rear stand 40b to connect the two legs 42 to each other. The beam between the two legs 42 may extend in a rod-like or plate-like shape along the gap G1. Also in this manner, the electronic device 10 can be stably set on the installation surface L2 by using the stand and the support 23.

(3) In the embodiment, the support 23 for supporting the electronic device 10 is the lower end of the protrusion formed on the lower surface 10D. In the example illustrated in FIG. 1, the shape of the support 23 viewed from below (Z2 direction) is a rectangle, but the shape of the support 23 is not limited thereto. The shape of the support 23 may be a polygon such as a triangle or a pentagon or may be a circle or an ellipse, for example. In addition, the shape of the support 23 may be a cross shape or a shape imitating other letters or symbols.

Moreover, the number of protrusions and supports 23 provided on the lower surface 10D of the electronic device 10 is not limited to one, and may be more than one. In this case, the sizes and shapes of a plurality of supports 23 when the electronic device 10 is viewed from below (Z2 direction) may be the same or different from each other. For example, protrusions in the shape of a triangle, a circle, a cross, or a square may be arranged on the lower surface 10D of the electronic device 10, and the supports 23 may be formed by these protrusions.

### [4. Summary]

(1)
   An electronic device assembly explained above in the present disclosure includes an electronic device and a first stand for supporting the electronic device, the first stand being attachable to and detachable from the electronic device. The electronic device includes a curved lower surface and a circuit board arranged in a posture along a direction intersecting with an up-down direction. The curved lower surface has a first position where the first stand is provided and a support a distance of which from a plane including the circuit board is greatest on the curved lower surface. This allows the electronic device to be set stably.
   (11)
      Further, an electronic device according to the present disclosure includes a curved lower surface and a circuit board arranged in a posture along a direction intersecting with an up-down direction. The curved lower surface has a first position where a first stand is provided and a support a distance of which from a plane including the circuit board is greatest on the curved lower surface. This allows the electronic device to be set stably.
   (12)
      Moreover, a stand according to the present disclosure is a stand that is attachable to and detachable from an electronic device, the stand including a first leg that has an upper end for fitting into a first mounting portion of the electronic device and extends downward from the upper end and a second leg that has an upper end for fitting into a second mounting portion of the electronic device and extends downward from the upper end. The first leg and the second leg have a common lower end. This allows the electronic device to be set stably.
(2) In the electronic device assembly according to (1) above, a distance from the plane including the circuit board to a lower end of the first stand may substantially be identical with the distance from the plane including the circuit board to the support.
(3) In the electronic device assembly according to (1) or (2) above, the electronic device may further include a device body housing the circuit board and an exterior panel attached to a lower surface of the device body. The curved lower surface may be formed on the exterior panel. The exterior panel may include a first portion panel covering a portion of the lower surface of the device body and a second portion panel covering another portion of the lower surface of the device body. The first position where the first stand is provided may be defined in a gap between the first portion panel and the second portion panel.
(4) In the electronic device assembly according to (3) above, the lower surface of the device body may have a mounting portion to which the first stand is attachable.
(5) The electronic device assembly according to any one of (1) to (4) above may include a second stand for supporting the electronic device. The curved lower surface may have a second position where the second stand is provided.
(6) In the electronic device assembly according to (5) above, the electronic device may include a device body housing the circuit board and an exterior panel attached to a lower surface of the device body. The curved lower surface may be formed on the exterior panel. The exterior panel may include a first portion panel covering a portion of the lower surface of the device body and a second portion panel covering another portion of the lower surface of the device body. The first position where the first stand is provided and the second position where the second stand is provided may be defined in a gap between the first portion panel and the second portion panel.
(7) In the electronic device assembly according to (5) or (6) above, the first stand and the second stand may have an identical shape.
(8) In the electronic device assembly according to any one of (3) to (7) above, the support may be formed on the first portion panel. A width of the first portion panel in a direction along the plane including the circuit board may be greater than a width of the second portion panel in the same direction.
(9) In the electronic device assembly according to any one of (3) to (8) above, the support may be provided on a protrusion formed on the first portion panel.
(10) In the electronic device assembly according to any one of (3) to (9) above, the gap may extend in a first direction along the plane including the circuit board. The first stand may have at least two legs that are spaced apart from each other in the first direction and are attached to the electronic device.

## Claims

1. An electronic device assembly comprising:
an electronic device; and
a first stand for supporting the electronic device, the first stand being attachable to and detachable from the electronic device, wherein
the electronic device includes a curved lower surface and a circuit board arranged in a posture along a direction intersecting with an up-down direction, and
the curved lower surface has a first position where the first stand is provided and a support a distance of which from a plane including the circuit board is greatest on the curved lower surface.

2. The electronic device assembly according to claim 1,
wherein
a distance from the plane including the circuit board to a lower end of the first stand is substantially identical with the distance from the plane including the circuit board to the support.

3. The electronic device assembly according to claim 1,
wherein
the electronic device further includes a device body housing the circuit board and an exterior panel attached to a lower surface of the device body,
the curved lower surface is formed on the exterior panel, the exterior panel includes a first portion panel covering a portion of the lower surface of the device body and a second portion panel covering another portion of the lower surface of the device body, and
the first position where the first stand is provided is defined in a gap between the first portion panel and the second portion panel.

4. The electronic device assembly according to claim 3,
wherein
the lower surface of the device body has a mounting portion to which the first stand is attachable.

5. The electronic device assembly according to claim 1, further comprising:
a second stand for supporting the electronic device,
wherein
the curved lower surface further has a second position where the second stand is provided.

6. The electronic device assembly according to claim 5, wherein
the electronic device further includes a device body housing the circuit board and an exterior panel attached to a lower surface of the device body,
the curved lower surface is formed on the exterior panel, the exterior panel includes a first portion panel covering a portion of the lower surface of the device body and a second portion panel covering another portion of the lower surface of the device body, and
the first position where the first stand is provided and the second position where the second stand is provided are defined in a gap between the first portion panel and the second portion panel.

7. The electronic device assembly according to claim 5, wherein
the first stand and the second stand have an identical shape.

8. The electronic device assembly according to claim 3, wherein
the support is formed on the first portion panel, and
a width of the first portion panel in a direction along the plane including the circuit board is greater than a width of the second portion panel in a same direction.

9. The electronic device assembly according to claim 3, wherein
the support is provided on a protrusion formed on the first portion panel.

10. The electronic device assembly according to claim 3, wherein
the gap extends in a first direction along the plane including the circuit board, and
the first stand has at least two legs that are spaced apart from each other in the first direction and are attached to the electronic device.

11. An electronic device comprising:
a curved lower surface; and
a circuit board arranged in a posture along a direction intersecting with an up-down direction, wherein
the curved lower surface has a first position where a first stand is provided and a support a distance of which from a plane including the circuit board is greatest on the curved lower surface.

12. A stand that is attachable to and detachable from an electronic device, the stand comprising:
a first leg that has an upper end for fitting into a first mounting portion of the electronic device and
extends downward from the upper end; and
a second leg that has an upper end for fitting into a second mounting portion of the electronic device and extends downward from the upper end, wherein
the first leg and the second leg have a common lower end.
